(19) **Europäisches Patentamt**

**European Patent Office**

**Office européen des brevets**

(11) Veröffentlichungsnummer: **0 060 337**
**B1**

(12) **EUROPÄISCHE PATENTSCHRIFT**

(45) Veröffentlichungstag der Patentschrift:
03.02.88

(21) Anmeldenummer: **81109282.4**

(22) Anmeldetag: **29.10.81**

(51) Int. Cl.⁴: **H 01 J 37/28**

(54) **Raster-Elektronenmikroskopanlage.**

(30) Priorität: **17.03.81 DE 3110311**

(43) Veröffentlichungstag der Anmeldung:
**22.09.82 Patentblatt 82/38**

(45) Bekanntmachung des Hinweises auf die Patenterteilung:
**03.02.88 Patentblatt 88/5**

(84) Benannte Vertragsstaaten:
**DE GB NL**

(56) Entgegenhaltungen:
**US-A-3 678 384**
**US-A-4 233 510**

**PATENTS ABSTRACTS OF JAPAN, Band 4, Nr. 10(E-167), 25. Januar 1980, Seite 9E167**

(73) Patentinhaber: **Siemens Aktiengesellschaft Berlin und München, Wittelsbacherplatz 2, D-8000 München 2 (DE)**

(72) Erfinder: **Touchy, Wolfgang, Dr. Dipl.- Phys., Severinstrasse 7, D-8000 München 90 (DE)**

EP 0 060 337 B1

**Beschreibung**

Die Erfindung bezieht sich auf eine Raster-Elektronenmikroskopanlage nach dem Oberbegriff des Patentanspruchs 1, wie auch aus der US-A-3 678 384 bekannt ist.

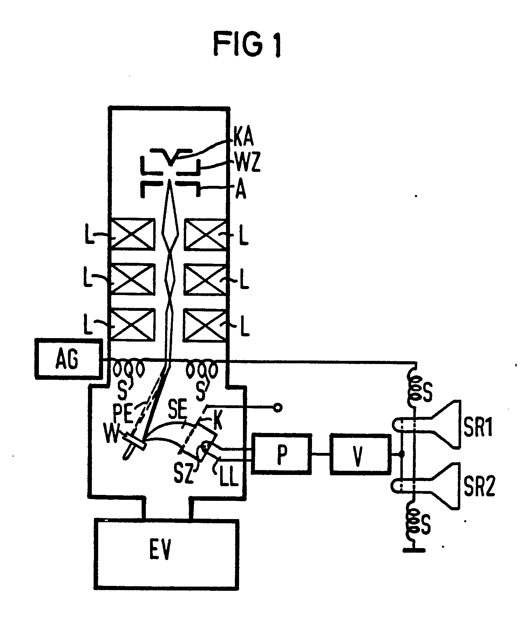

Eine übliche Anlage dieser Art ist schematisch in Figur 1 dargestellt, auf die zunächst eingegangen werden soll.

Wie bei allen solchen Anlagen wird der primäre Elektronenstrahl PE durch das aus einer Glühkathode oder sonstigen Elektronenquelle KA, einem Wehneltzylinder WZ und einer der Bildung des Elektronenstrahls dienenden Anode A bestehende und in bekannter Weise mit Betriebsspannungen versehene Erzeugungssystem in einem evakuiertem Raum erzeugt und mittels eines elektronischen Linsensystems L weitergeformt sowie unter Ablenkung gegen die Oberfläche des zu untersuchenden Objekts W fokussiert. Für die Ablenkung sind in bekannter Weise ausgebildete und von einem Ablenkgenerator AG mit der erforderlichen Ablenkspannung beaufschlagte Ablenkspulen S und für die Erzeugung des Vakuums in dem die Anlage aufnehmenden Behälter ein gesteuertes Evakuierungssystem EV vorgesehen.

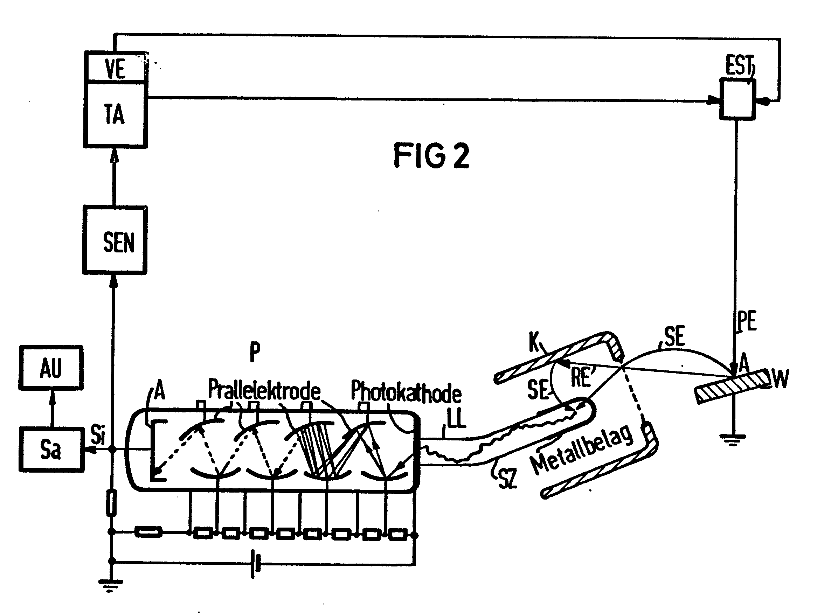

Die an der Oberfläche des zu untersuchenden Objekts W entstehenden Sekundärelektronen SE werden durch einen Kollektor K, der z. B. entsprechend einem in Elektronenröhren üblichen Gitter ausgebildet und durch eine entsprechende Spannungsquelle gesteuert ist, einem Szintillationsschirm SZ zugeleitet, an dessen Oberfläche sie sich beim Auftreffen durch Lichtpunkte bemerkbar machen, deren Dichte von der Zahl der durch den Primärstrahl PE erzeugten Sekundärelektronen abhängig ist. Über eine Lichtleitung LL, z. B. einer Glasfaseroptik, wird die optische und über den Szintillationsschirm erhaltene Information an die eigentliche Auswertestelle transportiert. Eine Darstellung der durch die Sekundärelektronen unmittelbar beeinflußten Teile der Anordnung ist übrigens in Fig. 2 in detaillierterer Form dargestellt. Die Auswertestelle besteht in dem gezeichneten Beispielsfall aus einer sog. Photomultiplieranlage mit einem nachgeschalteten Videoverstärker V, der zwei Bildröhren SR1 und SR2 steuert, von denen die eine als Sichtgerät (d. h. für unmittelbare visuelle Betrachtung) und die andere als Photoröhre (d. h. für die photographische Auswertung) dient. Der Ablenkgenerator AG liefert im Beispielsfalle auch für diese beiden Bildröhren SR1 und SR2 die für deren Ablenkspulen S erforderlichen Ablenkströme, so daß sowohl der Primärelektronenstrom PE als auch die Wiedergabeelektronenstrahlen in den Bildröhren synchron geführt werden. Einzelheiten über den Photomultiplier P sind aus Figur 2 ersichtlich.

Der für solche Rasterelektronenmikroskopanlagen gültige Stand der Technik ist z. B. in dem Buch von Reimer und Pfefferkorn "Raster-Elektronen-Mikroskopie" (Springer-Verlag, 2. Aufl. 1977), zusammengefaßt.

Bei der Rasterelektronenmikroskopie handelt es sich, wie schon der Name sagt, um eine Mikroskopie nach dem Rasterprinzip mit Hilfe von Elektronen. Die Auftreffstelle A des Primärelektronenstrahls PE wird dabei längs paralleler Linien entsprechend den Zeilen einer Fernsehaufnahmeröhre über die Oberfläche des zu untersuchenden bzw. abzubildenden Objekts W geführt, was durch den Ablenkgenerator AG gesteuert wird. Parallel zu diesem Abtastvorgang hat man eine Fernsehbildröhre SR1 bzw. SR2, deren Leuchtschirm mit den den Abtastlinien an der Oberfläche des Objekts W entsprechenden parallelen Linien beschrieben wird.

Die Menge, Dichte und die kinetischen Eigenschaften der an der Auftreffstelle A des primären Elektronenstrahls PE entstehenden Sekundärelektronen SE sind durch die physikalischen und geometrischen Eigenschaften des Werkstücks W an der Auftreffstelle A bestimmt. Sie lassen somit Rückschlüsse auf diese Eigenschaften zu, wenn man dafür sorgt, daß die Intensität des Elektronenstrahls in der Bild-Wiedergaberöhre SR1 bzw. SR2 ein Spiegelbild des Verhaltens der Intensität der längs der zugehörigen Abtastzeile an der Oberfläche des zu untersuchenden Objekts W ist.

Wünschenswert für ein derartiges REM (= Rasterelektronenmikroskop) sind vor allem zwei Dinge: Einmal sollte die Größe der Auftreffstelle A des primären Elektronenstrahls PE möglichst gering sein, da dann die Intensitätsänderung der vom Kollektor K eingefangenen Sekundärelektronendichte bei einer Änderung längs des Laufwegs der Auftreffstelle des primären Elektronenstrahls PE an der Oberfläche des zu untersuchenden Objekts W (z. B. beim Passieren einer Kante) umso ausgeprägter wird. Andererseits ist anzustreben, daß der Querschnitt des primären Elektronenstrahls PE an der Oberfläche des Werkstücks W ungeachtet etwa vorhandener Unebenheiten, z. B. Kanten, möglichst homogen bleibt. Schließlich wird die Bildauflösung des Systems von der Größe des Brennfleckes und von dem Volumen der "Anregungsbirne" im Werkstück W mitbestimmt.

Wenn der primäre Elektronenstrahl PE die Oberfläche des zu untersuchenden Objekts W trifft, dann entstehen neben den an der Oberfläche des Objekts reflektierten bzw. gestreuten Elektronen noch Sekundärelektronen SE. Dies sind sehr langsame Elektronen mit wenigen eV Energie, deren Entstehung auf die Auftreffstelle A des primären Elektronenstrahls beschränkt ist. Diese langsamen Sekundärelektronen werden von dem Kollektor K angezogen und gelang en dabei auf den Szintillator SZ an dem sie Lichtblitze erzeugen. Diese Lichtblitze werden im Photomultiplier P verstärkt und zur Hell-Dunkelsteuerung des Elektronenstrahls in der Wiedergaberöhre SR1 bzw. SR2 verwendet. Auch hier wird dafür gesorgt, daß die Ablenkung des primären Elektronenstrahls PE auf dem Werkstück W synchron zur Ablenkung des Elektronenstrahls in der Bildröhre SR1 bzw. SR2 ist. Die Intensitätsverteilung auf dem Bildschirm der Wiedergaberöhre entspricht somit der unterschiedlichen Zahl von Sekundärelektronen SE an den verschiedenen Auftreffstellen des Primärstrahls PE an der Oberfläche des Werkstücks W.

Der auf die Oberfläche des Werkstücks W, also des zu untersuchenden Objekts gemäß der eingangs gegebenen Definition auftreffende primäre Elektronenstrahl PE dringt erfahrungsgemäß in das Werkstück W ein, wobei in dessen Inneren die eindringenden Primärelektronen mehrfach gestreut, also in ihrer Richtung abgelenkt werden, wobei ein Teil der Primärelektronen PE das Werkstück W innerhalb eines Umkreises um die Auftreffstelle A als rückgestreute Elektronen wieder verläßt. Diese rückgestreuten Primärelektronen sind jedoch von der Natur des Werkstücks W und damit von der Auftreffstelle A weitgehend unabhängig und beeinflussen deshalb die Abbildung nicht. Hingegen sind erfahrungsgemäß die an der Auftreffstelle A durch den Primärelektronenstrahl PE erzeugten Sekundärelektronen praktisch ausschließlich von der Oberfläche des Werkstücks W an der Auftreffstelle A bestimmt.

Die Erfahrung zeigt ferner, daß umso mehr Sekundärelektronen SE die Oberfläche des zu untersuchenden Objekts W verlassen können, je mehr die Oberfläche an der Auftreffstelle A gegen den primären Elektronenstrahl geneigt ist. Dies führt u.a. dazu, daß man das beschriebene Verfahren bzw. die zu seiner Durchführung zu verwendende Apparatur mit Erfolg für die Längen- bzw. Breitenmessung von Oberflächenstrukturen bei der Herstellung von Halbleitervorrichtungen, z. B. bei der Herstellung von monolithisch integrierten Schaltungen, einsetzen kann, ohne daß es dabei zu einer Beschädigung der behandelten Halbleitervorrichtung kommt. Zu bemerken ist dabei, daß man die von den Sekundärelektronen SE am Ausgang des Photomultiplier P erhaltenen Signale Si auch zur Steuerung anderer Auswertemittel, als Fernsehbildröhren SR1, SR2, z. B. von Bildspeichern oder von Halbleiterdetektoren, einsetzen kann.

Gerade für die Längen- bzw. Breitenmessung bzw. der Messung der Schichtdicke der an der Oberfläche von Halbleiterkörpern erzeugten und sich aus unterschiedlichen Materrialien wie Photolack, $SiO_2$, $Si_3N_4$, Kontaktierungsmetall bzw. monokristallinem und polykristallinem Silcium, zusammensetzenden Strukturen wäre jedoch im Vergleich zu den bisher vorliegenden Möglichkeiten eine Steigerung der Anzeigeempfindlichkeit wünschenswert, so daß man mit einer möglichst niedrigen Intensität des primären Elektronenstrahls PE auskommt. Dann läßt sich nämlich die Größe des Auftreffflecks A in entsprechender Weise reduzieren und damit die Empfindlichkeit des Verfahrens analog dazu steigern. Außerdem kann gemessen werden, ohne die elektrischen Eigenschaften von Halbleiteranordnungen, insbesondere MOS-Systemen, zu verändern.

Diese Aufgabe wird erfindungsgemäß durch eine Raster-Elektronenmikroskopanlage der eingangs genannten Art gelöst, welche die kennzeichnenden Merkmale des Patentanspruchs 1 aufweist.

Der Erfindung liegt dabei folgendes Konzept zugrunde: Mit einem Spezial-REM (REM = Raster-Elektronenmikroskop) wird ein "line-scan" in Schritten erzeugt und über die auszuwertende Oberfläche des zu untersuchenden Werkstücks, insbesondere des Layouts an der Oberfläche einer auszumessenden Halbleiterstruktur, gelegt. Dabei wird die Energie des primären Elektronenstrahls höchstens auf den Wert von 3 keV eingestellt, so daß die Primärelektronen zwar in die die monokristalline Halbleiteroberfläche an allen Stellen bedeckenden Isolier- bzw. Kontaktierungsschichten aber nicht in das darunter liegende einkristalline Halbleitermaterial in merklichem Ausmaß eindringen können. Außerdem wird der primäre Elektronenstrahl PE durch ein beam-blanking-System so gepulst, daß in dem Werkstück W kein meßbarer Strom sich für längere Zeit ausbilden kann. Aus diesem Grund wird das aufgrund der Sekundärelektronen SE am Ausgang des Photomultipliers P entstehende Signal Si mit zur Steuerung der Tastung des primären Elektronenstrahls PE herangezogen, die dafür sorgt, daß der primäre Elektronenstrahl PE erst dann wieder in Aktion tritt, wenn die Aufladung an der Auftreffstelle A in dem erforderlichen Maß wieder abgeklungen bzw. wieder völlig verschwunden ist.

Bevorzugt ist die Steuerung der Verschiebung der Auftreffstelle A des primären Elektronenstrahls PE an der Oberfläche des zu untersuchenden Objekts W auf die Tastung des Elektronenstrahls PE zudem so abgestimmt, daß ein Wechsel der Auftreffstelle A ebenfalls auf eine Unterbrechungspause des primären Elektronenstrahls beschränkt ist. Gegebenenfalls kann es aber auch zweckmäßig sein, wenn die Verschiebung der Auftreffstelle in der aktiven Phase des primären Elektronenstrahls PE erfolgt. Die erste der soeben genannten Möglichkeiten empfiehlt sich, wenn es sich um sehr gute Isolatoren als Objekt W handelt, während die zweite Möglichkeit dann angebracht ist, wenn das Objekt W leitend oder halbleitend ist.

Beim Betrieb der erfindungsgemäßen Anlage wird, wie bereits erwähnt, der primäre Elektronenstrahl PE so gepulst, daß kein meßbarer Strom im Werkstück W entsteht, bzw. eine sich bei aktivem Primärelektronenstrahl bildende Aufladung an der Oberfläche in der Taktpause wieder verschwindet. Die in mehrmaligen "Schüssen" auf dieselbe Stelle A der Oberfläche des zu testenden Werkstücks W entstehenden Signale Si werden gesammelt und dann die nächste "line-scan"-Stelle an der Oberfläche des Werkstücks W beschossen. So entsteht eine Signalkurve Si als Profil der zu messenden Struktur, die der in üblicher Weise, z. B. mittels des mittels Goldbestäubung durchgeführten "line-scan", erhaltenen Signalkurve entspricht. Die Auswertung erfolgt in üblicher Form, z. B. durch einen Rechner, indem die erste und/oder die zweite Ableitung die Meßkurve festlegt, mit der Vorgabe vergleicht und einen Ätz- oder sonstigen Fertigungsprozeß stopt, wenn die Vorgabe erreicht ist.

Dasselbe Verfahren eignet sich zur Längenausmessung von Potentialprofilen auf Halbleiter-Schrägschliffen, wodurch z. B. die Lage von pn-Übergängen, die effektive Kanallänge von MOS-FET's usw. bestimmt werden kann.

Eine weitere Anwendung des erfindungsgemäßen Prinzips der Signalsammlung ist die digitale Erzeugung eines Bildes der Oberfläche des zu untersuchenden Objekts W. Dieses Bild kann auch aus "Erzeugungsmustern" zusammengesetzt werden, indem der primäre Elektronenstrahl EP adressiert wird. Darunter ist folgendes Vorgehen zu verstehen: Der primäre Elektronenstrahl PE wird so bewegt, daß sein Auftreffpunkt A auf der vorgesehenen Bahn örtlich zwischen zwei oder mehreren Stellen dieser Bahn hin und her springt. Beispielsweise springt der Auftreffpunkt A von einer Stelle am Anfang auf eine Stelle in der Mitte dieser Bahn und von der zuletzt genannten Stelle wieder auf die erstgenannte Stelle zurück. Diese Verschiebung wirkt offensichtlich wie eine Tastpause und erlaubt eine bessere Ausnutzung der Taktpausen für die einzelnen Abtastpunkte.

Weiter führt, wie ersichtlich, das erfindungsgemäße Verfahren dazu, daß das Werkstück keine merkliche Belastung erfährt, da die Pausen zwischen den für eine gegebene Abtaststelle an der Oberfläche des Werkstücks W gegebenen Pausen für eine elektrische Neutralisierung der Werkstückoberfläche auch dann sorgen, wenn die Oberfläche des Werkstücks aus hochisolierendem Material besteht. Wesentlich für das Signal-Sammlungsprinzip gemäß der Erfindung ist außerdem, daß man die Energie des primären Elektronenstrahls drastisch drosseln kann. Dies bedeutet, daß der Auftrefffleck A entsprechend klein eingestellt werden kann und dennoch wegen des angewendeten Sampling-Prinzips dennoch die zur Auswertung erforderliche Leistung zur Verfügung gestellt wird. Jedenfalls führt das erfindungsgemäße Vorgehen zu einer merklichen Steigerung der Bildauflösung.

Eine für das beschriebene Verfahren notwendige Apparatur gemäß der Erfindung ist, was die Erzeugung des primären Elektronenstrahls PE und die Verschiebung seines Auftreffflecks an der Oberfläche des zu untersuchenden Objekts W betrifft, in üblicher Weise, z. B. gemäß Figur 1, beschaffen. Sie hat jedoch noch weitere, in Figur 2 im Blockschaltbild dargestellte Bestandteile, deren Realisierung jedoch keine besonderen Schwierigkeiten bereiten dürfte.

Ferner ist zu bemerken, daß die Ausbildung des Photomultipliers P, des Lichtleiters LL, der Szintillationsanlage SZ und des Kollektors K dem Stande der Technik gemäß dem bereits genannten Buch von Reimer und Pfefferkorn (siehe S. 87) entspricht, so daß auf eine Beschreibung von Einzelheiten (die übrigens in Fig. 2 dargestellt sind) hier verzichtet werden kann. Desweiteren ist die unmittelbare Steuerung EST des primären Elektronenstrahls PE durch die bereits aus Fig. 1 ersichtlichen Mittel (Wehneltzylinder, Anodenspannung) gegeben.

Die gemäß der Erfindung vorzusehenden Apparateteile bestehen aus einem durch das am Ausgang der Photomultiplizieranlage P erscheinende und im übrigen an die Auswertestelle (z. B. über einen Verstärker V gemäß Fig. 1) gehende Signal Si beaufschlagten Sensor SEN und einer durch den Sensor SEN ein- und auszuschaltenden Steueranlage ST. Diese weist einen Teil TA auf, der für die Tastung des primären Elektronenstrahls PE bestimmt ist, sowie einen Teil VE, der für die Einstellung der Auftreffstelle A des primären Elektronenstrahls auf der Oberfläche des zu untersuchenden Werkstücks W sowie dessen Verschiebung zuständig ist.

Der Sensor SEN soll einerseits bei einem Mindestwert, insbesondere beim Wert "Null" des Auswertesignals Si den Primärelektronenstrahl PE einschalten und beim Überschreiten eines vorgesehenen bestimmten Maximalwertes dieses Auswertesignals Si wieder ausschalten. Beispielsweise kann man hierzu einen Schmitt-Trigger mit zwei positiven Triggerschwellen verwenden, wie er z. B. auf S. 135 des Buches "Halbleiter-Schaltungstechnik" (1980) von Tietze und Schenk beschrieben ist.

Da das Ausgangssignal Si aus physikalischen Gründen sich so verhält, daß nach seinem Einschalten nicht nur die Amplitude sondern auch deren Ableitung nach der Zeit monoton ansteigt, kann man außerdem dem direkten Signal Si auch dessen Ableitung zum Ein- bzs. Abschalten des primären Elektronenstrahles PE verwenden.

Beispielsweise besteht der Sensor dann aus einer Differenzierstufe, die durch das Signal Si beaufschlagt ist. Im Ruhezustand der Anordnung, also im ladungsfreien Zustand der Oberfläche des zu untersuchenden Objekts W, d.h. also bei ausgeschaltetem primären Elektronenstrahl PE ist der Ausgang einer solchen Differenzstufe signalfrei und befindet sich daher auf dem Pegel "Null". Da mit der Dauer der Beaufschlagung einer Auftreffstelle A an der Oberfläche eines Werkstücks W nicht nur die Amplitude sondern auch die Ableitung des Signals Si monoton ansteigt, erreicht auch die Spannung am Ausgang einer als Sensor SEN verwendeten Differenzierstufe einen positiven und gerade für den Betrieb des primären Elektronenstrahls PE noch vorgesehenen Höchstwert. Steigt nun die Amplitude des Signals Si weiter, so erfolgt dann aufgrund des vom Sensor SEN abgegebenen Signals die Unterbrechung des primären Elektronenstrahls PE solange, bis die Amplitude bzw. die Ableitung des Signals Si auf den Wert "Null" abgeklungen ist, worauf der primäre Elektronenstrahl PE erneut eingeschaltet wird.

Die Verschiebung der Auftreffstelle A längs der für diese vorgesehenen Zeile auf der Oberfläche des zu untersuchenden bzw. auszumessenden Werkstücks W erfolgt zweckmäßig jedesmal nach einer fest vorgegebenen Anzahl von Einschaltevorgängen für den primären Elektronenstrahl PE. Hierzu kann man z. B. die den primären Elektronenstrahl PE betreffenden Ein- bzw. Ausschaltvorgänge über einen Digitalzähler überwachen, bei dem bestimmte Zählstände jeweils zur Auslösung der Verschiebung der Auftreffstelle von einem endgültig zu verlassenden Platz zu einem neu zu bearbeitenden Platz an der vorgegebenen Abtastzeile verwendet werden, indem die Ablenkspannung für den primären Elektronenstrahl um einen die Verschiebung der Auftreffstelle A um einen vorgegebenen Abstand von der vorherigen Auftreffstelle bewirkenden Spannungswert verändert wird. Im allgemeinen wird man die Auftreffstellen A längs der einzelnen Abtastzeilen äquidistant über diese verteilen und auch den Abstand zwischen benachbarten Abtastzeilen in entsprechender Weise bemessen. Dabei ist es ohne weiteres mit in der Elektronenoptik üblichen Mitteln erreichbar, daß der primäre Elektronenstrahl, falls die Verschiebung im ausgeschalteten Zustand erfolgte, automatisch erneut wieder eingeschaltet wird.

Der die Tastung des primären Elektronenstrahls PE bewirkende Teil TA der Steueranlage ST besteht also im einfachsten Fall lediglich aus einer Konstantspannungsquelle zum Sperren des primären Elektronenstrahls PE, die über den Sensor SEN bei einem Mindestwert des Signals Si ausgeschaltet und bei einem vorgegebenen Maximalwert wieder eingeschaltet wird. Beispielsweise kann man hierzu neben den bereits angegebenen Möglichkeiten folgende Möglichkeit verwenden: Man verwendet zwei Komparatoren, z. B. Differenzverstärker, deren einer Eingang jeweils durch das Signal Si und deren anderer Eingang durch eine geeignete Referenzspannung beaufschlagt ist. Diese ist so bemessen, daß der eine Komparator beim vorgesehenen Minimalwert des Signals Si ein beiden Komparatoren nachgeschaltetes Flip-Flop in den einen Betriebszustand und der andere Komparator beim vorgesehenen Maximalwert von Si dieses Flip-Flop in den anderen Zustand umschaltet. Einer der beiden Ausgänge des Flip-Flops dient zur Steuerung der Basis eines Schalttransistors, mit dessen Hilfe die den primären Elektronenstrahl sperrende Gleichspannung ein- bzw. ausgeschaltet wird.

Der der Ablenkung des primären Elektronenstrahls PE und damit der Verschiebung von dessen Auftreffstelle A dienende Teil der Steuerung ST, also die Anlage VE, ist an sich in üblicher Weise als Zeilenablenkschaltung ausgebildet. Die Ablenkspannung, die von dieser Zeilenablenkspannung, also dem Ablenkgenerator AG gemäß Figur 1 geliefert wird, wird jedoch solange auf dem vorher eingestellten Wert festgehalten, bis ein entsprechendes Freigabesignal von dem die Tastung bewirkenden Teil TA, z. B. vermittels des bereits genannten Dualzählers, eine Verschiebung der Auftreffstelle vom alten Ort zu einem neu einzustellenden Ort an der Oberfläche des Werkstücks W erlaubt.

Die Auswertung der am Ausgang des Photomultipliers abgegebenen Signale Si erfolgt über eine Signalsammelanlage Sa, in welcher die zu einer Abtaststelle für den primären Elektronenstrahl PE gehörenden Signale Si gesammelt und dann gemeinsam der eigentlichen Auswertung AU, z. B. der Intensitätssteuerung der Elektronenstrahlen in den Fernsehröhren SR1 bzw. SR2 zugeführt werden. Ein einfaches Beispiel für eine solche Signalsammelanlage Sa ist ein Kondensator, dem die jeweils zu derselben Abtaststelle gehörenden Signale Si zugeführt werden. Man muß dann dafür sorgen, daß die Ladung im Kondensator solange erhalten bleibt, als zurselben Abtaststelle gehörende Signale Si geliefert werden. Erst mit dem Abklingen des letzten zu einer gegebenen Abtaststelle gehörenden Signals Si und dem damit verbundenen Abschluß des Sammelprozesses wird der Kondensator entleert, um für die Aufnahme der zur nächsten Abtaststelle gehörenden Signale Si vorbereitet zu sein. Beispielsweise können die Signale Si über den Verstärker V oder über eine in Flußrichtung gepolte Diode der Sammelstelle Sa zugeführt werden, während zur Entladung des Sammelkondensators das von der Auswertung AU gelieferte Signal dient.

Wird das oben angegebene Prinzip der Adressierung angewendet, so wird man die zu den einzelnen abwechselnd getasteten Abtaststellen gehörenden Signal dementsprechend auf eine der Anzahl der nebeneinander durch den primären Elektronenstrahl PE beaufschlagten Auftreffstellen entsprechende Anzahl von Sammelanlagen Sa verteilen, derart, daß jede Sammelanlage durch je eine der gleichzeitig behandelten Abtaststellen zugeteilt ist. Außerdem sorgt ein Zähler in diesem Fall dafür, daß stets nur die jeweils zu einer bestimmten der nebeneinander behandelten Auftreffstellen gehörenden Signale Si sowohl zur Einstellung der Unterbrechungspausen für die genannte Auftreffstelle als auch zur Beaufschlagung der in einer gegebenen Phase der Abtastung des zu untersuchenden Objekts W der genannten Auftreffstelle zugeteilten Sammelanlage vorgesehen sind.

## Patentansprüche

1. Raster-Elektronenmikroskopanlage für die Untersuchung der Oberfläche von Werkstücken, mit einer Anlage zur Verschiebung der Auftreffstelle eines gegen die Oberfläche des zu untersuchenden Objektes gerichteten primären Elektronenstrahles, einer Anlage zur Tastung des an der Auftreffstelle Sekundärelektronen auslösenden primären Elektronenstrahles und einem Sekundärelektronendetektor zur Erzeugung eines Auswertesignals gekennzeichnet durch einen mit dem Auswertesignal (SI) beaufschlagten Sensor (SEN), der eine dem Sensor (SEN) nachgeschaltete Steueranlage (EST), die einen für die Tastung des primären Elektronenstrahles (PE) bestimmten ersten Schaltungsteil (TA) und einen für die Einstellung der Auftreffstelle (A) und deren Verschiebung bestimmten zweiten Schaltungsteil (VE) aufweist, derart beeinflußt, daß eine Verschiebung der Auftreffstelle (A) jeweils erst nach einer oder mehreren Unterbrechungen des primären Elektronenstrahles (PE) aufgrund der Tastung desselben eintritt und daß die Dauer der jeweiligen Unterbrechung über die an der Auftreffstelle (A) des primären Elektronenstrahles (PE) ausgelösten Sekundärelektronen (SE) gesteuert wird.

2. Anlage nach Anspruch 1, dadurch gekennzeichnet, daß die Auftreffenergie des primären Elektronenstrahls (PE) auf höchstens 3 keV eingestellt ist.

3. Anlage nach Anspruch 1 oder 2, dadurch gekennzeichnet, daß dieselbe Auftreffstelle (A) des primären Elektronenstrahls (PE) wenigstens über zwei - insbesondere unmittelbar aufeinanderfolgende - Unterbrechungspausen des primären Elektronenstrahls (PE) beibehalten wird.

4. Anlage nach einem der Ansprüche 1 bis 3, dadurch gekennzeichnet, daß die einzelnen Änderungen der Auftreffstelle (A) des primären Elektronenstrahls (PE) auf die Unterbrechungspausen beschränkt sind.

5. Anlage nach einem der Ansprüche 1 bis 4, dadurch gekennzeichnet, daß in der Unterbrechungspause für eine erste Auftreffstelle des primären Elektronenstrahls (PE) dieser gegen eine zweite Auftreffstelle gerichtet und dann wieder auf die erste Auftreffstelle zurückgeschaltet ist.

6. Anlage nach einem der Ansprüche 1 bis 5, dadurch gekennzeichnet, daß die aufgrund der an den einzelnen Auftreffstellen an der Oberfläche des zu untersuchenden Objekts (W) entstehenden Sekundärelektronen (SE) gebildeten Signale pro Auftreffstelle mittels einer Sammelanlage (Sa) eine Zusammenfassung zu einem Gesamtsignal erfahren und dieses Gesamtsignal der eigentlichen Auswertestelle (AU) zugeführt wird.

## Claims

1. A scanning electron microscope system for surface investigation of workpieces, comprising means to displace the point of impact of a primary electron beam directed towards that surface of an object which is to be investigated, means for keying the primary electron beam which triggers secondary electrons at the point of impact, and a secondary electron detector which generates an analysis signal, characterised by a sensor (SEN) supplied with the analysis signal (SI) and influencing a control system (EST) connected to the output of the sensor (SEN) and comprising a first circuit component (TA) to key the primary electron beam (PE) and a second circuit component (VE) to set and displace the point of impact (A) such that the point of impact (A) is displaced only following one or more interruptions in the primary electron beam (PE) as a result of the keying thereof, the duration of each interruption being controlled via the secondary electrons (SE) triggered at the point of impact (A) of the primary electron beam (PE).

2. A system as claimed in Claim 1, characterised in that the impact energy of the primary electron beam (PE) is set at a maximum of 3 keV.

3. A system as claimed in Claims 1 or 2, characterised in that the same point of impact (A) of the primary electron beam (PE) is retained for at least two - in particular directly consecutive - interruption pauses of the primary electron beam (PE).

4. A system as claimed in one of Claims 1 to 3, characterised in that the individual changes of the point of impact (A) of the primary electron beam (PE) are limited to the interruption pauses.

5. A system as claimed in one of Claims 1 to 4, characterised in that in the interruption pause for a first point of impact of the primary electron beam (PE) the latter is directed towards a second point of impact and is then redirected towards the first point of impact.

6. A system as claimed in one of Claims 1 to 5, characterised in that the signals formed in respect of each point of impact as a result of the secondary electrons (SE) which occur at the individual points of impact on that surface of the object (W) to be investigated are combined by a collecting system (Sa) to form a collective signal and that this collective signal is supplied to the actual analysis station (AU).

## Revendications

1. Installation électronique à balayage pour examiner la surface de pièces usinées, avec un dispositif pour déplacer le point d'impact d'un rayon électronique primaire sur la surface de l'objet à examiner, avec un dispositif pour manipuler le rayon électronique primaire libérant des électrons secondaires au point d'impact, et avec un détecteur d'électrons secondaires pour produire un signal d'évaluation, caractérisée par un détecteur (SEN) recevant le signal d'évaluation (SI) et influençant de telle manière un premier élément de circuit (TA) destiné à la manipulation du rayon électronique primaire (PE) et un second élément de circuit (VE) destiné au réglage du point d'impact et son déplacement, qu'un déplacement de point d'impact (A) n'intervient qu'après une ou plusieurs interruption du rayon éléctronique primaire (PE) du fait de la manipulation de ce dernier, et que la durée de l'interruption est commandée par les électrons secondaires (SE) libérés au niveau du point d'impact (A) du rayon électronique primaire (PE).

2. Installation selon la revendication 1, caractérisée par le fait que l'énergie de l'impact du rayon électronique primaire (PE) est réglée à 3 keV au maximum.

3. Installation selon la revendication 1 ou 2, caractérisée par le fait que le même point d'impact (A) du rayon électronique primaire (PE) est conservé pendant deux des intervalles entre interruptions du rayon électronique primaire (PE), en particulier deux intervalles qui se suivent directement.

4. Installation selon l'une des revendications 1 à 3, caractérisée par le fait que les diverses modifications du point d'impact (A) du rayon électronique primaire (PE) sont limitées aux intervalles entre interruptions.

5. Installation selon l'une des revendications 1 à 4, caractérisée par le fait que durant l'intervalle entre interruptions pour un premier point d'impact de rayon électronique primaire (PE), ce dernier est dirigé vers un second point d'impact et est ensuite ramené sur le premier point d'impact.

6. Installation selons l'une des revendications 1 à 5, caractérisée par le fait que les signaux qui sont formés par suite des électrons secondaires (SE) issus au niveau des différénts points d'impact sur la surface de l'objet (W), subissent, par point d'impact et à l'aide d'une installation collectrice (Sa), un collationnement pour la formation d'un signal total et que ce signal total est appliqué au poste d'évaluation proprement dit (AU).

# FIG 1

FIG 2